(19) Europäisches Patentamt
European Patent Office
Office européen des brevets

(11) **EP 4 414 728 A1**

(12) **DEMANDE DE BREVET EUROPEEN**

(43) Date de publication:
**14.08.2024 Bulletin 2024/33**

(21) Numéro de dépôt: **24156014.3**

(22) Date de dépôt: **06.02.2024**

(51) Classification Internationale des Brevets (IPC):
**G01R 31/392** (2019.01)    **G01R 31/388** (2019.01)
**A24F 40/90** (2020.01)    **H02J 7/00** (2006.01)

(52) Classification Coopérative des Brevets (CPC):
**G01R 31/392; G01R 31/388;** G01R 31/378

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: **10.02.2023 FR 2301285**

(71) Demandeur: **STMicroelectronics International N.V.**
**1228 Plan-les-Ouates, Geneva (CH)**

(72) Inventeur: **LADRET, Daniel**
**LANS-EN-VERCORS 38250 (FR)**

(74) Mandataire: **Cabinet Beaumont**
**4, Place Robert Schuman**
**B.P. 1529**
**38025 Grenoble Cedex 1 (FR)**

(54) **MESURE DE LA CAPACITE D'UNE BATTERIE**

(57)    La présente description concerne un procédé de mesure de la capacité effective d'une batterie comprenant une première mesure (202), pendant un phénomène de relaxation de ladite batterie, d'une première tension délivrée par ladite batterie en cours d'utilisation à partir d'une durée,
ladite durée étant la différence entre un premier instant initial et un deuxième instant défini comme étant l'instant auquel une première droite, tangente à l'origine d'une courbe correspondant à l'évolution temporelle d'une tension délivrée par ladite batterie pendant ledit phénomène de relaxation, atteint une deuxième tension délivrée par ladite batterie quand elle est relaxée.

Fig 2

**Description**

Domaine technique

La présente description concerne de façon générale les batteries d'accumulateurs, appelées couramment batteries, et concerne de façon plus particulière les batteries de type Lithium Ferro-Phosphate. La présente description se rapporte plus particulièrement à des procédés de mesure de la capacité effective et du vieillissement d'une telle batterie.

Technique antérieure

Les batteries d'accumulateurs, appelées couramment batteries, sont utilisées aujourd'hui de façon très courante pour alimenter toutes sortes de dispositifs électroniques.

Parmi les différents types de batteries existants, les batteries au lithium sont très utilisées pour alimenter des petits objets électroniques portables comme des téléphones portables, des objets connectés, des cigarettes électroniques, etc. Les batteries Lithium Ferro-Phosphate et les batteries Lithium-Cobalt-Oxyde sont des exemples de batteries au lithium.

Une batterie est caractérisée par différentes valeurs, dont sa capacité qui indique la quantité de courant qu'une batterie peut fournir au fil du temps, et son vieillissement qui indique son degré de dégradation.

Il serait souhaitable de pouvoir améliorer, au moins en partie, au moins certains aspects des procédés de mesure de la capacité et du vieillissement d'une batterie.

Résumé de l'invention

Il existe un besoin pour un procédé de mesure de la capacité d'une batterie plus simple d'utilisation et consommant moins d'énergie.

Il existe un besoin pour un procédé de mesure du vieillissement d'une batterie plus simple d'utilisation et consommant moins d'énergie.

Un mode de réalisation pallie tout ou partie des inconvénients des procédés connus de mesure de la capacité d'une batterie.

Un mode de réalisation prévoit un procédé de mesure de la capacité d'une batterie plus simple d'utilisation.

Un mode de réalisation prévoit un procédé de mesure de la capacité d'une batterie consommant moins d'énergie.

Un mode de réalisation prévoit un procédé de mesure du vieillissement d'une batterie plus simple d'utilisation.

Un mode de réalisation prévoit un procédé de mesure du vieillissement d'une batterie consommant moins d'énergie.

Un mode de réalisation pallie tout ou partie des inconvénients des procédés connus de mesure du vieillissement d'une batterie.

Un mode de réalisation prévoit un procédé de mesure de la capacité effective d'une batterie comprenant une première mesure, pendant un phénomène de relaxation de ladite batterie, d'une première tension délivrée par ladite batterie en cours d'utilisation à partir d'une durée,
ladite durée étant la différence entre un premier instant initial et un deuxième instant défini comme étant l'instant auquel une première droite, tangente à l'origine d'une courbe correspondant à l'évolution temporelle d'une tension délivrée par ladite batterie pendant ledit phénomène de relaxation, atteint une deuxième tension délivrée par ladite batterie quand elle est relaxée.

Selon un mode de réalisation, le phénomène de relaxation de ladite batterie est obtenu en effectuant une charge partielle de ladite batterie jusqu'à ce que ladite batterie requière un courant de fin de charge, le phénomène de relaxation apparaissant lorsque ladite charge partielle est arrêtée.

Selon un mode de réalisation, la valeur du courant de fin de charge est définie comme étant égale à la capacité typique de ladite batterie divisée par 10 heures.

Selon un mode de réalisation, ladite charge partielle est effectuée à courant constant et à tension constante.

Selon un mode de réalisation, ladite capacité effective est donnée par la formule mathématique suivante :

[Math 3]

$$Ceff = Ctyp - R\bigl(Vr - V(tr)\bigr)$$

dans laquelle :

- Ceff est la capacité effective ;
- Ctyp représente la capacité typique de ladite batterie ;
- R représente la résistance de ladite batterie ;
- Vr représente la tension délivrée par ladite batterie quand ladite batterie est relaxée ; et
- V(tr) représente ladite première tension.

Selon un mode de réalisation, le procédé comprend, en outre, une deuxième mesure de ladite résistance de la batterie.

Selon un mode de réalisation, la deuxième mesure est réalisée en effectuant une deuxième décharge de ladite batterie avec un premier courant.

Selon un mode de réalisation, le premier courant est supérieur à 500 mA.

Selon un mode de réalisation la première décharge est la deuxième décharge.

Selon un mode de réalisation, ladite batterie est une batterie de type Lithium Ferro-Phosphate.

Un autre mode de réalisation prévoit un procédé de mesure du vieillissement d'une batterie comprenant le procédé décrit précédemment.

Selon un mode de réalisation, le vieillissement d'une batterie est défini comme étant le rapport de la capacité effective de la batterie par la capacité typique de la batterie.

Un autre mode de réalisation prévoit une cigarette électronique adaptée à mettre en oeuvre le procédé de mesure d'une capacité décrit précédemment.

Un autre mode de réalisation prévoit une cigarette électronique adaptée à mettre en oeuvre le procédé de mesure du vieillissement décrit précédemment.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente, très schématiquement, une batterie de type Lithium Ferro-Phosphate ;

la figure 2 représente un schéma-bloc illustrant un mode de mise en oeuvre d'un procédé de mesure de la capacité effective d'une batterie et un mode de mise en oeuvre d'un procédé de mesure du vieillissement d'une batterie ;

la figure 3 représente une courbe illustrant la réalisation d'une étape des procédés de la figure 2 ;

la figure 4 représente des courbes illustrant la réalisation d'une autre étape des procédés de la figure 2 ; et

la figure 5 représente un exemple pratique d'utilisation de la batterie de la figure 1.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Les modes de réalisation décrits ci-après se rapportent à la détermination de la capacité d'une batterie au lithium, et plus particulièrement d'une batterie de type Lithium Ferro-Phosphate, ou batterie à lithium-fer-phosphate, ou batterie de type ferrophosphate de lithium, et du vieillissement d'une telle batterie. Les modes de réalisation concernent plus particulièrement deux procédés de mesure de la capacité et du vieillissement d'une batterie présentant une plus grande facilité de mise en oeuvre et consommant moins d'énergie.

Dans la suite de la description, la capacité d'une batterie est définie comme une valeur, exprimée en Ampère-heure (A/h), indiquant la quantité de courant que peut fournir une batterie au fil du temps. La capacité d'une batterie se dégrade au fil de temps, et les raisons de cette dégradation sont, par exemple, le temps lui-même, l'utilisation de la batterie, les conditions de stockage de la batterie comme la température et/ou l'humidité, etc.

On appelle, par la suite, capacité typique, la capacité que présente une batterie à la fin de sa fabrication. Pour finir, on appelle, capacité effective, capacité courante, ou capacité réelle d'une batterie, la capacité que présente une batterie à un instant donné. La capacité effective d'une batterie est nécessairement inférieure à la capacité typique de cette même batterie.

De plus, dans la suite de la description, le vieillissement d'une batterie, ou état de santé (State of Health) d'une batterie, est défini par le rapport de la capacité effective par la capacité typique de cette batterie. Le vieillissement peut être exprimé sous forme de pourcentage. Le vieillissement permet d'évaluer un degré de dégradation d'une batterie.

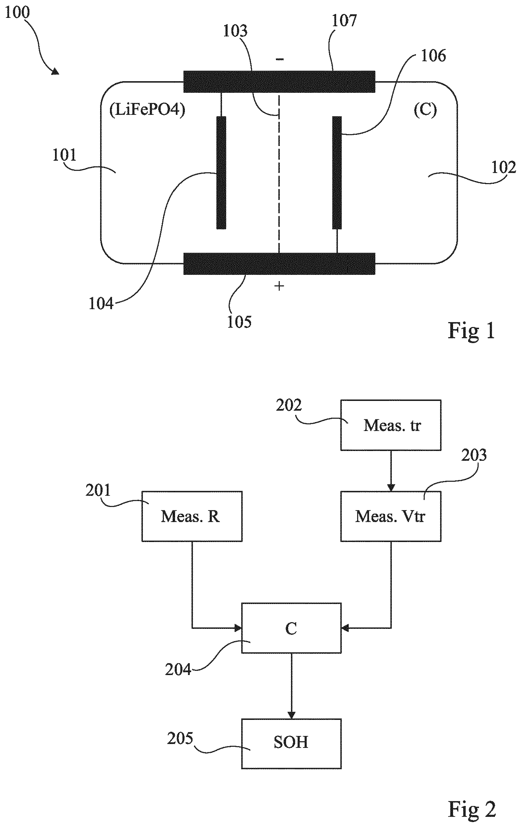

La figure 1 représente, très schématiquement, une batterie au lithium de type Lithium Ferro-Phosphate 100.

La batterie 100 comprend la structure d'une batterie de type Lithium Ferro-Phosphate typique. La batterie 100 comprend deux compartiments 101 (LiFePO4) et 102 (C) séparés par une membrane poreuse 103.

Le compartiment 101 est rempli d'une structure cristalline de phosphate de fer lithié permettant l'insertion et la désinsertion d'atomes de lithium. Le compartiment 101 est traversé par une électrode métallique 104, par exemple en aluminium, constituant l'électrode positive, ou cathode, de la batterie 100. L'électrode 104 est en contact direct avec la structure de phosphate de fer lithié. L'électrode 104 est, en outre, reliée à une borne de connexion 105 formant la borne de cathode de la batterie 100.

Le compartiment 102 est rempli d'une structure cristalline de carbone, par exemple du graphite, permettant l'insertion et la désinsertion d'atomes de lithium. Le compartiment 102 est traversé par une électrode métallique 106, par exemple en cuivre, constituant l'électrode négative, ou anode, de la batterie 100. L'électrode 106 est en contact direct avec la structure de carbone. L'électrode 106 est, en outre, reliée à une borne de connexion 107 formant la borne d'anode de la batterie 100.

La membrane poreuse 103 est adaptée à ne laisser passer que les atomes de lithium. Selon un exemple, la membrane 103 est en polymère.

Lors de la charge de la batterie 100, les atomes de lithium présents dans le compartiment 101 migrent vers le compartiment 102, c'est-à-dire migrent depuis la cathode vers l'anode.

Lors de la décharge de la batterie 100, les atomes de lithium présents dans le compartiment 102 migrent vers le compartiment 101, c'est-à-dire migrent depuis l'anode vers la cathode.

La figure 2 est un schéma-bloc illustrant un mode de mise en oeuvre d'un procédé de mesure de la capacité effective d'une batterie du type de la batterie 100 décrite en relation avec la figure 1, et un mode de mise en oeuvre d'un procédé de mesure du vieillissement d'une telle batterie.

Selon un mode de réalisation, la capacité effective Ceff d'une batterie est donnée par la formule mathématique suivante :

[Math 1]

$$Ceff = Ctyp - R\bigl(Vr - V(tr)\bigr)$$

dans laquelle :

- Ctyp représente la capacité typique de la batterie ;
- R représente la résistance de la batterie ;
- Vr représente la tension délivrée par la batterie quand elle est relaxée ; et
- V(tr) représente la tension délivrée par la batterie en cours d'utilisation définie ci-après.

Selon un mode de réalisation, le vieillissement SOH de cette même batterie est donnée par la formule mathématique suivante :

[Math 2]

$$SOH = \frac{Ceff}{Ctyp}$$

Pour calculer la capacité effective Ceff et le vieillissement de la batterie, il est nécessaire d'avoir à disposition la capacité typique de la batterie, c'est généralement une donnée présente dans la fiche technique de la batterie, elle est donc considérée comme connue ici.

De plus, il est nécessaire d'avoir à disposition, la valeur de la tension Vr représentant la tension délivrée par la batterie quand elle est relaxée. Une batterie de type Lithium Ferro-Phosphate présente, comme d'autres batteries, un phénomène de relaxation apparaissant après application d'un courant entre les bornes de la batterie, par exemple pour la charger. Plus particulièrement, quand un courant a été envoyé à la batterie, la tension de sortie de la batterie varie pendant une durée non nulle, appelée durée de relaxation, avant de se stabiliser. Une fois que la tension de sortie de la batterie est stable, la batterie est dite relaxée. La valeur de la tension délivrée par la batterie lorsqu'elle est relaxée est généralement une donnée présente dans la fiche technique de la batterie, elle est donc considérée comme connue ici. Selon un autre exemple, une mesure de cette tension de relaxation peut être réalisée comme décrit ci-après.

Plus particulièrement, une batterie de type Lithium Ferro-Phosphate, comme la batterie 100 décrite en relation avec la figure 1, présente un phénomène de relaxation après chaque application d'un courant entre ses bornes. Selon un exemple, pour une batterie de ce type fournissant en sortie une tension de l'ordre de 3,6 V après application d'un courant, une fois que le phénomène de relaxation est apparu, sa tension de sortie est inférieure à 3,6 V.

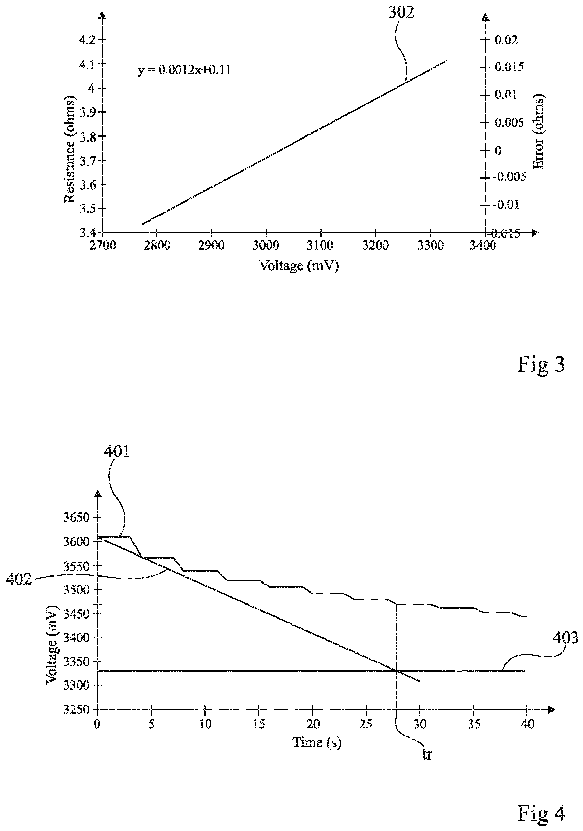

A une étape 201 (Meas. R), une mesure de la résistance R de la batterie est mise en oeuvre. Pour cela, la batterie est déchargée avec un courant relativement élevé. Selon un exemple, pour une batterie ayant une capacité typique de l'ordre de 0,2 A/h ou de l'ordre de 1,6 A/h, un courant relativement élevé est un courant de l'ordre de 800 mA. Des mesures du courant et de la tension délivrés par la batterie sont effectuées tout au long de cette décharge. Un exemple de courbe obtenue lors d'une telle décharge est décrit plus en détail en relation avec la figure 3.

Une régression linéaire est réalisée à partir de ces mesures de tension et de courant, et la valeur de la résistance électrique, appelée ci-après résistance, de la batterie est déduite du coefficient directeur de la droite de la régression linéaire. Plus de détails sont donnés en relation avec la figure 3.

A une étape 202 (Meas. tr), une mesure d'un instant tr, et d'une durée Dr correspondante, est mise en oeuvre. Pour cela, un phénomène de relaxation est induit dans la batterie à tester. Les étapes suivantes sont mises en oeuvre :

- une étape de décharge ;
- une étape de charge partielle de la batterie jusqu'à atteindre un courant de fin de charge de la batterie ; et
- observation du phénomène de relaxation et mesure de l'instant tr.

Selon un exemple, l'étape 202 peut être directement mise en oeuvre après l'étape 201, et l'étape de décharge de la batterie de l'étape 202 peut être, ainsi, l'étape de décharge de l'étape 201.

L'étape de charge de la batterie peut être mise en oeuvre en fournissant un courant constant Itr et une tension constante à la batterie, aussi appelée paramétrage CCCV. Selon un exemple, le courant constant Itr est compris entre 0.5 et 5 A, par exemple de l'ordre de 1 A. Selon un exemple, la tension constante est comprise entre 1 et 5 V, par exemple de l'ordre de 3.6 V.

De plus, selon un mode de réalisation, le courant de fin de charge de la batterie est défini comme le courant apporté à la batterie à la fin de sa charge. En pratique, on fixe ce courant comme étant égal à la capacité typique de la batterie divisée par dix heures.

Une fois que l'étape de charge est terminée, le courant et la tension appliqués à la batterie sont mis à zéro, et la tension délivrée par la batterie est mesurée. Dès que la charge est arrêtée, la tension délivrée par la batterie se met à décroître jusqu'à atteindre un palier. Un exemple de courbe obtenue par cette mesure est décrit plus en détails en relation avec la figure 4. Le palier atteint par la tension correspond à la tension Vr, c'est-à-dire la tension délivrée par la batterie lorsqu'elle est relaxée. Selon un exemple, une mesure de la tension Vr peut être effectuée à cette étape.

De plus, à l'étape 202, l'instant tr est mesuré. L'instant tr est l'instant auquel la tangente à l'origine de l'évolution temporelle de la tension délivrée par la batterie, pendant le phénomène de relaxation, atteint la valeur de la tension Vr. Autrement dit, l'instant tr est l'instant où cette tangente croise la droite horizontale définie par l'équation y = Vr. La détermination de l'instant tr est décrite plus en détails en relation avec la figure 4.

Il est déduit de la mesure de l'instant tr, une mesure d'une durée Dr correspondant à la différence entre l'instant tr et un instant initial correspondant au démarrage du phénomène de relaxation.

Les étapes 201 et 202 sont des étapes de caractérisation de la batterie. Elles peuvent toutes les deux être mises en oeuvre dès la fabrication de la batterie. Les valeurs qu'elles permettent de calculer sont, en théorie, indépendante du vieillissement de la batterie.

A une étape 203 (Meas. V(tr)), une mesure de la tension V(tr) est mise en oeuvre. La tension V(tr) est la valeur de la tension délivrée par la batterie lorsqu'elle est en cours d'utilisation. Autrement dit, dès qu'un dispositif utilisant la batterie est mis en fonctionnement et commence à être alimenté par la batterie, une mesure de la tension délivrée par la batterie est effectuée au bout de la durée Dr, correspondant à la durée de l'instant tr. Autrement dit, quand le dispositif entre en fonctionnement, un instant initial est défini, et dès que l'instant tr est atteint, la tension délivrée par la batterie est mesurée, cette tension étant la tension V(tr). Cette étape peut être mise en oeuvre à n'importe quel utilisation de la batterie ou du dispositif électronique comprenant la batterie.

La tension V(tr) est dépendante du vieillissement de la batterie, cette étape fournit donc une valeur caractéristique de l'état de santé de la batterie.

A une étape 204 (C), postérieure aux étapes 201 à 203, la détermination de la capacité effective de la batterie est mise en oeuvre en utilisant les valeurs récoltées aux étapes 201 à 203. Plus particulièrement, l'équation Math 1 définie précédemment est utilisée pour calculer la valeur de la capacité effective Ceff.

A une étape 205 (SOH), postérieure à l'étape 204, la détermination du vieillissement est mise en oeuvre en utilisant la valeur de la capacité effective récoltée à l'étape 204. Plus particulièrement, l'équation Math 2 définie précédemment est utilisée pour calculer la valeur du vieillissement.

Ainsi, le mode de mise en oeuvre du procédé de mesure de la capacité effective de la batterie comprend les étapes 201 à 204, et le mode de mise en oeuvre du procédé de mesure du vieillissement de la batterie comprend les étapes 201 à 205.

Un avantage de ces modes de mise en oeuvre, est qu'il est facile d'utilisation. De plus, il peut être mis en oeuvre par un dispositif embarqué associé à une batterie, sans nécessiter une grande dépense en énergie. En effet, la charge effectuée à l'étape 202 n'est réalisée que jusqu'à atteindre le courant de fin de charge de la batterie, et non pas la capacité typique de la batterie. Selon un exemple, une telle charge peut être n'importe quelle charge de la batterie mise en oeuvre pendant son utilisation. Autrement dit, l'étape 202 peut profiter d'une charge de la batterie pour être mise en oeuvre.

La figure 3 est un graphique représentant une courbe 301 obtenue lors de l'étape de mesure 201 décrite en relation avec la figure 2.

La courbe 301 représente une régression linéaire de la valeur de la tension délivrée par la batterie en fonction de la valeur du courant délivré par cette batterie pendant la décharge mise en oeuvre à l'étape 201. Selon un exemple, pour obtenir la courbe 301 un circuit, tel qu'un processeur, un microprocesseur, un contrôleur, ou un microcontrôleur, réalise des mesures de courant et de tension. Selon un exemple, la courbe 301 est obtenue par une jauge de type Gas Gauge permettant de surveiller une seule cellule de batterie. Ces mesures peuvent être réalisées de façon synchronisée ou de façon non synchronisée. Selon un exemple pratique, les valeurs de courant sont relevées toutes les 500 ms et les valeurs de tension sont relevées toutes les 4 s.

La valeur de la résistance électrique de la batterie est obtenue en déterminant le coefficient directeur de la droite 301 et en utilisant la loi d'Ohm.

La figure 4 est un graphique représentant des courbes 401 à 403 obtenues lors de l'étape de mesure 203 décrite en relation avec la figure 2.

La courbe 401 représente l'évolution temporelle de la tension délivrée par la batterie pendant le phénomène de relaxation induit pendant l'étape 202. Selon un exemple, les mesures de valeur de tension sont mesurées tous les 1 à 5 s, par exemple toutes les 3 s.

La courbe 402, ou droite 402, est la tangente à l'origine de la courbe 401, c'est-à-dire la tangente au point de la courbe 401 ayant pour abscisse 0.

La courbe 403, ou droite 403, est une droite horizontale ayant pour ordonnée la tension Vr délivrée par la batterie lorsqu'elle est relaxée.

Comme décrit précédemment, l'instant tr est défini comme étant l'abscisse du point intersection entre les droites 402 et 403.

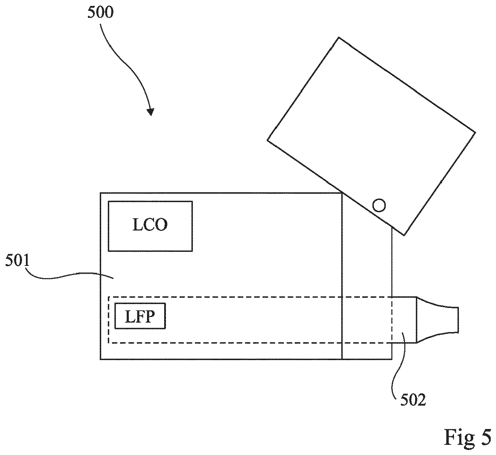

La figure 5 représente un exemple pratique d'application de tels procédés. Plus particulièrement, la figure 5 représente une cigarette électronique 500.

La cigarette électronique 500 est composée d'un étui 501 dans lequel est inséré un porte-cigarette 502.

L'étui 501 comprend une batterie ayant une grande capacité de stockage, comme par exemple une batterie lithium-ion de type lithium-Cobalt-Oxyde. L'étui 501 a pour fonction de servir de chargeur sans fil au porte cigarette 502. L'étui peut comprendre, en outre, un écran d'affichage, comme, par exemple, un ensemble de diodes électroluminescentes.

Le porte-cigarette 502 est adapté à comprendre et à être alimentée en énergie par une batterie du type de la batterie 100 décrite en relation avec la figure 1. Le porte-cigarette 502 utilise plutôt une batterie de ce type pour des raisons de sécurité. En effet, les batteries de type Lithium-Ferro-Phosphate présentent un phénomène d'emballement technique moins important que les autres batteries de type Lithium-ion. De plus, les batteries de type Lithium-Ferro-Phosphate présentent un temps de charge plus court que les autres batteries. Ce temps de charge plus court est dû à une capacité d'absorption de courant plus importante d'une batterie Lithium-Ferro-Phosphate, une telle batterie peut être chargée jusqu'à cinq fois sa capacité typique sans vieillissement prématuré.

Le porte-cigarette 502 peut, en outre, comprendre un module électronique associé à sa batterie. Ce module peut être adapté à mettre en oeuvre les modes de mise en oeuvre des procédés de mesure décrits en relation avec la figure 2. Selon un exemple, ce module peut être un processeur, un microprocesseur, un contrôleur, ou un microcontrôleur.

Selon un autre exemple, ce module peut être une jauge de type Gas Gauge.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, d'autres dispositifs électroniques sont adaptés à mettre en oeuvre les modes de mise en oeuvre des procédés décrits en relation avec la figure 2.

Enfin, la mise en oeuvre pratique des modes de réalisation et variantes décrits est à la portée de la personne du métier à partir des indications fonctionnelles données ci-dessus.

**Revendications**

1. Procédé de mesure de la capacité effective (Ceff) d'une batterie (100) comprenant une première mesure (202), pendant un phénomène de relaxation de ladite batterie (100), d'une première tension (V(tr)) délivrée par ladite batterie (100) en cours d'utilisation à partir d'une durée (Dr), ladite durée (Dr) étant la différence entre un premier instant initial et un deuxième instant (tr) défini comme étant l'instant auquel une première droite (402), tangente à l'origine d'une courbe (401) correspondant à l'évolution temporelle d'une tension délivrée par ladite batterie (100) pendant ledit phénomène de relaxation, atteint une deuxième tension (Vr) délivrée par ladite batterie (100) quand elle est relaxée.

2. Procédé selon la revendication 1, dans lequel le phénomène de relaxation de ladite batterie (100) est obtenu en effectuant une charge partielle de ladite batterie jusqu'à ce que ladite batterie (100) requière un courant de fin de charge, le phénomène de relaxation apparaissant lorsque ladite charge partielle est arrêtée.

3. Procédé selon la revendication 2, dans lequel la valeur du courant de fin de charge est définie comme étant égale à la capacité typique de ladite batterie divisée par 10 heures.

4. Procédé selon la revendication 2 ou 3, dans lequel ladite charge partielle est effectuée à courant constant et à tension constante.

5. Procédé selon la revendication 3 ou 4, dans lequel ladite capacité effective (Ceff) est donnée par la formule mathématique suivante :

[Math 3]

$$Ceff = Ctyp - R\big(Vr - V(tr)\big)$$

dans laquelle :

- Ceff est la capacité effective ;
- Ctyp représente la capacité typique (Ctyp) de ladite batterie (100) ;
- R représente la résistance (R) de ladite batterie (100) ;
- Vr représente la tension délivrée par ladite batterie (100) quand ladite batterie (100) est relaxée ; et
- V(tr) représente ladite première tension.

6. Procédé selon l'une quelconque des revendications 1 à 5, comprenant, en outre, une deuxième mesure de ladite résistance (R) de la batterie (100).

7. Procédé selon la revendication 6, dans lequel la deuxième mesure (201) est réalisée en effectuant une deuxième décharge de ladite batterie (100) avec un premier courant.

8. Procédé selon la revendication 7, dans lequel le premier courant est supérieur à 500 mA.

9. Procédé selon la revendication 8 dans son rattachement à la revendication 2, dans lequel la première décharge est la deuxième décharge.

10. Procédé selon l'une quelconque des revendications 1 à 9, dans lequel ladite batterie (100) est une batterie (100) de type Lithium Ferro-Phosphate.

**11.** Procédé de mesure du vieillissement d'une batterie (100) comprenant le procédé selon l'une quelconque des revendications 1 à 10.

**12.** Procédé selon la revendication 11, dans lequel le vieillissement d'une batterie (100) est défini comme étant le rapport de la capacité effective (Ceff) de la batterie (100) par la capacité typique de la batterie (100).

**13.** Cigarette électronique adaptée à mettre en oeuvre le procédé selon l'une quelconque des revendications 1 à 10.

**14.** Cigarette électronique adaptée à mettre en oeuvre le procédé selon la revendication 11 ou 12.

Fig 1

Fig 2

y = 0.0012x+0.11

Fig 3

Fig 4

500

LCO

501

LFP

502

Fig 5

Europäisches
Patentamt

European
Patent Office

Office européen
des brevets

# RAPPORT DE RECHERCHE EUROPEENNE

Numéro de la demande

EP 24 15 6014

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | EP 3 870 986 B1 (PSA AUTOMOBILES SA [FR]) 8 juin 2022 (2022-06-08) | 1-4,6-14 | INV.<br>G01R31/392 |
| A | * alinéas [0020] - [0056]; revendications 1-8; figures 1-4 * | 5 | G01R31/388<br>A24F40/90<br>H02J7/00 |
| X | WO 2017/050944 A1 (COMMISSARIAT ENERGIE ATOMIQUE [FR]) 30 mars 2017 (2017-03-30) | 1-4,6-14 | |
| A | * page 8 - page 16; revendications 1-21; figures 1-4 * | 5 | |
| A | JP 2022 011801 A (DENSO CORP) 17 janvier 2022 (2022-01-17) * alinéas [0007] - [0064]; revendications 1-4; figures 1-11 * | 1-14 | |
| A | US 6 707 272 B1 (THANDIWE IILONGA [US]) 16 mars 2004 (2004-03-16) * figure 4 * | 1-14 | |
| A | US 2021/396816 A1 (ZOMINY CLAUDE [FR] ET AL) 23 décembre 2021 (2021-12-23) * alinéas [0032] - [0056]; revendications 1-15; figures 1A-4 * | 5,13,14 | DOMAINES TECHNIQUES RECHERCHES (IPC)<br><br>G01R<br>H02J |
| A | EP 3 701 816 B1 (JAPAN TOBACCO INC [JP]) 27 juillet 2022 (2022-07-27) * le document en entier * | 5,13,14 | A24F<br>H01M |

Le présent rapport a été établi pour toutes les revendications

| Lieu de la recherche | Date d'achèvement de la recherche | Examinateur |
|---|---|---|
| Munich | 29 mai 2024 | Bilzer, Claus |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...........................................................................
& : membre de la même famille, document correspondant

EPO FORM 1503 03.82 (P04C02)

**EP 4 414 728 A1**

## ANNEXE AU RAPPORT DE RECHERCHE EUROPEENNE
## RELATIF A LA DEMANDE DE BREVET EUROPEEN NO.

EP 24 15 6014

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

29-05-2024

| Document brevet cité au rapport de recherche | | Date de publication | Membre(s) de la famille de brevet(s) | | Date de publication |
|---|---|---|---|---|---|
| EP 3870986 | B1 | 08-06-2022 | CN | 112912746 A | 04-06-2021 |
| | | | EP | 3870986 A1 | 01-09-2021 |
| | | | FR | 3087393 A1 | 24-04-2020 |
| | | | WO | 2020084212 A1 | 30-04-2020 |
| WO 2017050944 | A1 | 30-03-2017 | FR | 3041764 A1 | 31-03-2017 |
| | | | WO | 2017050944 A1 | 30-03-2017 |
| JP 2022011801 | A | 17-01-2022 | CN | 115720689 A | 28-02-2023 |
| | | | EP | 4175005 A1 | 03-05-2023 |
| | | | JP | 2022011801 A | 17-01-2022 |
| | | | US | 2023118313 A1 | 20-04-2023 |
| | | | WO | 2022004356 A1 | 06-01-2022 |
| US 6707272 | B1 | 16-03-2004 | AUCUN | | |
| US 2021396816 | A1 | 23-12-2021 | CN | 113039698 A | 25-06-2021 |
| | | | EA | 202191406 A1 | 03-09-2021 |
| | | | EP | 3900150 A1 | 27-10-2021 |
| | | | JP | 7365413 B2 | 19-10-2023 |
| | | | JP | 2022510870 A | 28-01-2022 |
| | | | US | 2021396816 A1 | 23-12-2021 |
| | | | WO | 2020127091 A1 | 25-06-2020 |
| EP 3701816 | B1 | 27-07-2022 | CN | 111278304 A | 12-06-2020 |
| | | | EP | 3701816 A1 | 02-09-2020 |
| | | | EP | 3864982 A1 | 18-08-2021 |
| | | | EP | 4268643 A2 | 01-11-2023 |
| | | | JP | 6778981 B2 | 04-11-2020 |
| | | | JP | WO2019082249 A1 | 02-07-2020 |
| | | | KR | 20200061410 A | 02-06-2020 |
| | | | TW | 201916822 A | 01-05-2019 |
| | | | US | 2020245688 A1 | 06-08-2020 |
| | | | US | 2022369723 A1 | 24-11-2022 |
| | | | WO | 2019082249 A1 | 02-05-2019 |

EPO FORM P0460